(19)

**Europäisches Patentamt**
**European Patent Office**
**Office européen des brevets**

(11) **EP 4 783 457 A1**

(12) **EUROPEAN PATENT APPLICATION**

(43) Date of publication:
**29.07.2026 Bulletin 2026/31**

(21) Application number: **25153280.0**

(22) Date of filing: **22.01.2025**

(51) International Patent Classification (IPC):
***H03B 23/00*** *(2006.01)*

(52) Cooperative Patent Classification (CPC):
**H03B 23/00;** H03B 2201/0208

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(71) Applicant: **NXP B.V.**
**5656 AG Eindhoven (NL)**

(72) Inventors:
• **SARIC, Taric**
**5656AG Eindhoven (NL)**

• **LU, Chuang**
**5656AG Eindhoven (NL)**
• **PAVLOVIC, Nenad**
**5656AG Eindhoven (NL)**
• **BREEMS, Lucien Johannes**
**5656AG Eindhoven (NL)**

(74) Representative: **Schwarzweller, Thomas**
**NXP Semiconductors Germany GmbH**
**Intellectual Property Group**
**Beiersdorfstraße 12**
**22529 Hamburg (DE)**

(54) **NON-UNIFORM COARSE DCO STEPS FOR IMPROVED CHIRP LINEARITY**

(57)    A radar system uses a phase locked loop to generate an FMCW signal. The phase-locked loop has an LC oscillator having a coarse bank of capacitors, a first fine bank of capacitors, and a second fine bank of capacitors. A chirp controller uses non-uniform coarse frequency steps for the chirp operation. A randomly selected control setting for the second fine bank of capacitors is used in conjunction with the coarse bank of capacitors to generate the non-uniform coarse frequency steps. The first fine bank of capacitors is used to generate frequencies between coarse frequency steps as part of the chirp operation. Scale factor corrections are used to generate control settings for the second fine capacitor bank to reduce error.

Fig. 8

## Description

## BACKGROUND

## Technical Field of the Invention

The present disclosure relates to controlling an oscillator of a phase-locked loop circuit for chirp operations.

## Description of the Related Art

Phase-locked loops (PLLs) are widely employed in radio, telecommunications, computers and other electronic applications. They can be used to modulate and demodulate a signal, recover a signal from a noisy communication channel, generate a stable frequency at multiples of an input frequency, or distribute precisely timed clock pulses in digital logic circuits such as microprocessors. In radar applications used, e.g., for range sensing, a phase-locked loop generates linearly frequency modulated signals. Distances to objects or persons are determined based on the frequency difference between transmitted and reflected waves. The accuracy of distance measurements is sensitive to deviations and errors in the linearly frequency-modulated signals. Accordingly, improvements in the linearity of the frequency-modulated signals is desirable.

## SUMMARY OF EMBODIMENTS OF THE INVENTION

In embodiments according to a first aspect, a method includes generating an output signal of a an oscillator. The output signal has a frequency ramp that increases or decreases from a starting frequency to an ending frequency. The method further includes the oscillator using non-uniform coarse frequency steps to generate the output signal.

In an embodiment the method further includes generating the non-uniform coarse frequency steps by using a coarse capacitance of a coarse capacitor bank in conjunction with a randomly selected fine capacitance of a fine capacitor bank.

In an embodiment the method further includes storing coarse capacitance control codes and fine capacitance control codes in a memory.

In an embodiment the method further includes storing a plurality of frequency thresholds, each of the frequency thresholds being a combination of a first frequency corresponding to one of the coarse capacitance control codes in combination with a second frequency corresponding to a randomly selected one of the fine capacitance control codes.

In an embodiment the method further includes receiving an indication of a desired frequency to be generated by an oscillator of the phase-locked loop for a chirp operation, determining one of the frequency thresholds that has a threshold frequency below the desired frequency, determining a residual frequency based on a difference between the desired frequency and the threshold frequency, and determining a second fine capacitance control code for a second fine bank of capacitors using the residual frequency.

In an embodiment the method further includes using calibration data to scale the residual frequency based on a current coarse frequency step determined according to the one of the frequency thresholds and a stored scaling factor.

In an embodiment the method further includes adjusting the stored scaling factor to account for a frequency difference between a current coarse frequency step and a coarse frequency step used during calibration.

In an embodiment the method further includes, for each coarse frequency step, supplying one of the coarse capacitance control codes to a coarse bank of capacitors and supplying one of the fine capacitance control codes to a fine bank of capacitors.

In an embodiment the method further includes for each coarse frequency step, sequencing through a plurality of fine control codes for the second fine bank of capacitors.

In embodiments according to a second aspect, an apparatus includes a phase-locked loop that includes an oscillator having a coarse bank of capacitors, a first fine bank of capacitors, and a second fine bank of capacitors. The apparatus includes a chirp controller that supplies the oscillator with control codes for the first fine bank of capacitors and the coarse bank of capacitors that cause the phase-locked loop to utilize non-uniform coarse frequency steps to generate the output signal.

In an embodiment of the apparatus the first fine bank of capacitors is used in conjunction with the coarse bank of capacitors to generate the coarse frequency steps.

In an embodiment of the apparatus each of the plurality of coarse frequency steps is determined according to a coarse capacitance control code supplied to the coarse bank of capacitors and a fine capacitance control code is randomly selected to be simultaneously supplied to the second fine bank of capacitors.

In an embodiment of the apparatus a plurality of fine capacitance control codes are supplied to the second fine bank of capacitors between coarse frequency steps as part of the chirp operation.

In an embodiment the apparatus includes a memory to store coarse capacitance control codes including the coarse capacitance control code and fine capacitance control codes including the fine capacitance control code and scale factors for the fine capacitance control codes.

In an embodiment the memory further stores a plurality of first frequency thresholds, each of the first frequency thresholds being a frequency determined by one of the coarse capacitance control codes in combination with a random one of the fine capacitance control codes.

In an embodiment the chirp controller receives an indication of a desired frequency to be generated by an oscillator for the chirp operation and the chirp controller performs a threshold search of a plurality of frequency thresholds to find a threshold frequency among the frequency thresholds that is closest to and below the desired frequency, each of the frequency thresholds corresponding to first frequency corresponding to one of the coarse capacitance control codes summed with a second frequency corresponding to one of the fine capacitance control codes randomly assigned to the one of the coarse capacitance control codes.

In an embodiment of the apparatus the chirp controller determines a residual frequency based on a difference between the desired frequency and the threshold frequency and the chirp controller determines a second fine capacitance control code for a second fine bank of capacitors using the residual frequency.

In other embodiments according to a third aspect, a method includes generating an output signal of an oscillator of phase-locked loop (PLL) for use in a chirp operation. The method further includes the oscillator using non-uniform coarse frequency steps to generate the output signal, each of the non-uniform coarse frequency steps generated using a coarse capacitance of a coarse capacitor bank in the oscillator in combination with a randomly selected fine capacitance of a first fine capacitor bank in the oscillator and the oscillator using a second fine capacitor bank to adjust a frequency of the output signal between the non-uniform coarse frequency steps.

In an embodiment the method further includes correcting a scale factor used to generate fine capacitance control settings for the first fine capacitor bank to reduce error due to a mismatch between a first threshold associated with a uniform coarse frequency step used during calibration and a second threshold associated with a non-uniform coarse frequency step used during operation.

The method may further include correcting the scale factor by interpolating between uniform coarse step scale factors.

## BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.

FIG. 1 illustrates a high level block diagram of a radar system.

FIG. 2 illustrates an example of a chirp signal generated by a frequency modulated continuous wave (FMCW) radar system.

FIG. 3 illustrates a high level block diagram of an all-digital phase-locked loop (ADPLL) for use in chirp generation.

FIG. 4 illustrates the coarse index, the fine index, and the resulting periodic error that can occur using uniform coarse frequency steps.

FIG. 5 illustrates calibration data available in one or more lookup tables (LUTs) in embodiments.

FIG. 6A shows pseudo code illustrating generation of lookup table (LUT) entries used to randomize the coarse step.

FIG. 6B illustrates varying the coarse step size in terms of frequency and duration for 5 coarse steps.

FIG. 7 illustrates an example where coarse thresholds are combined with the extra fine thresholds to generate non-uniform frequency steps over multiple chirps.

FIG. 8 illustrates a block diagram of an embodiment of a control algorithm that utilizes a combined lookup table (coarse and extra fine combined) to generate non-uniform coarse frequency steps in the DCO.

FIG. 9A illustrates the coarse index and fine index using non-uniform coarse steps.

FIG. 9B illustrates the frequency error versus samples for 10 chirps.

FIG. 10 illustrates pseudo code used to provide a scale factor correction.

FIG. 11 illustrates graphical aspects of another embodiment for scale factor correction.

FIG. 12A illustrates frequency error without the scale factor correction.

FIG. 12B illustrates the frequency error with scale factor correction.

The use of the same reference symbols in different drawings indicates similar or identical items.

## DETAILED DESCRIPTION

Embodiments described herein provide a radar system that uses non-uniform coarse frequency steps for a digitally controlled oscillator (DCO) in a PLL during a chirp operation. The use of non-uniform coarse frequency steps provides improved frequency modulated continuous wave (FMCW) chirp linearity. In an embodiment the PLL includes multiple capacitor banks in the DCO to modulate the frequency of the DCO output signal to achieve the frequency ramp associated with the chirp. A residual frequency error that is related to the DCO segmentation structure can result in a periodic frequency error. The segmentation structure refers to the different capacitor banks (coarse and fine) used to modulate the frequency of the PLL output signal. There is a tradeoff between frequency error and calibration time and thus a frequency error can be present even after calibration, particularly if the calibration time is limited due to operational requirements. Embodiments herein include an additional capacitor bank that is used to create non-uniform coarse frequency transitions, resulting in suppressed periodicity of the frequency error signal. Each chirp uses non uniform coarse steps to achieve randomization as the frequency is swept and embodiments also utilize different non-uniform coarse steps for different chirps.

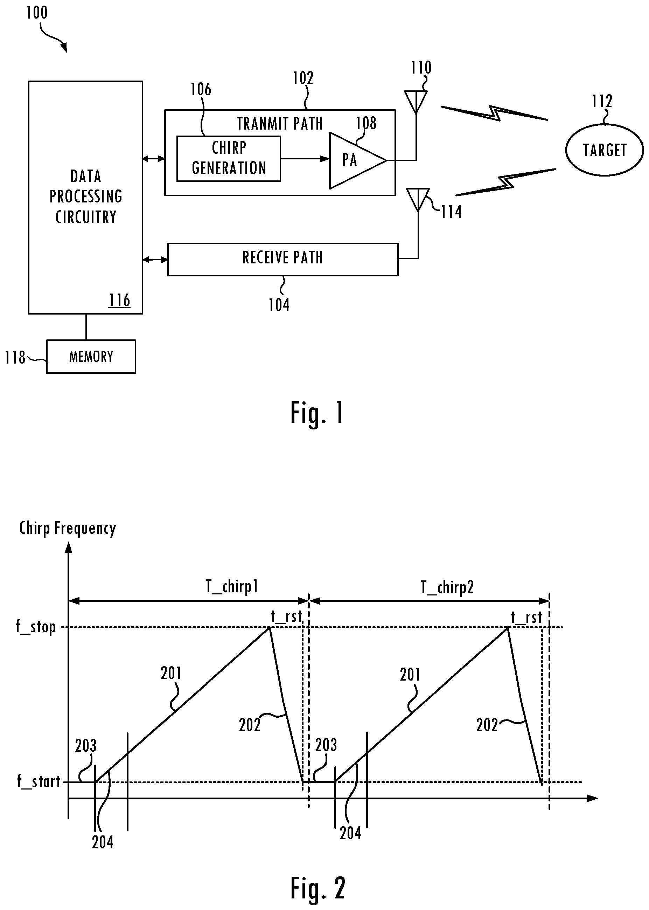

Fig. 1 illustrates a high level block diagram of a radar system 100 that includes a transmit path 102 and a receive path 104. The transmit path 102 includes the chirp generation circuit 106 that generates a chirp signal with increased linearity as described further herein. The chirp signal is supplied to a power amplifier 108 and transmitted over transmit antenna 110. The transmitted signal is reflected by the target 112 and received at antenna 114. The receive path includes, e.g., a passive network coupled to the antenna, a low noise amplifier, a programmable gain amplifier, an analog to digital converter, and appropriate filters. The data processing circuitry 116 provides control for both the transmit path and the receive path and appropriate digital signal processing and other processing required by radar system 100. The data processing circuitry 116 may include one or more processing units. Memory 118 stores code and data for system 100. While the memory is shown as a single memory coupled to data processing circuitry 116, memory 118 may include multiple types of memory, e.g., random access memory (RAM), both static and dynamic, non-volatile memory, registers, and other storage devices and is accessible to various parts of the radar system 100.

The illustrated radar system 100 is a frequency modulated continuous wave (FMCW) radar system. An FMCW radar system transmits a frequency modulated continuous wave. When the transmitted signal hits an object, the object reflects back the transmitted wave to the radar system with a different frequency. The radar system can then determine both the target range and velocity based on the frequency change and timing of the return signal. FMCW radar systems have a wide variety of applications. For example, FMCW radar is commonly used in automotive radar systems, e.g., for adaptive cruise control and object detection. FMCW radar can also be used for ranging in drones and for altimeters in aircraft to measure height above the ground. FMCW radar can also be used for applications such as imaging and detection through walls, as security sensors to detect intrusion, and even to detect and measure human vital signs.

Fig. 2 illustrates an example of a chirp signal generated by FMCW radar system 100 during a chirp operation. During a chirp operation, the chirp generation circuit generates a chirp signal 201 having a frequency that is swept from the starting frequency (f_start) to the stopping frequency (f_stop). The frequency can start, e.g., in the 78 GHz range. The transmitted signal from radar system 100 typically includes multiple chirps during a chirp operation although only two are shown in Fig. 2 for ease of illustration. The chirp signals are reset during time 202 and the chirps may further include a dwell time 203 and a settle time 204. Linearity errors in the chirp signal 201 adversely affects radar performance and embodiments described herein improve chirp linearity.

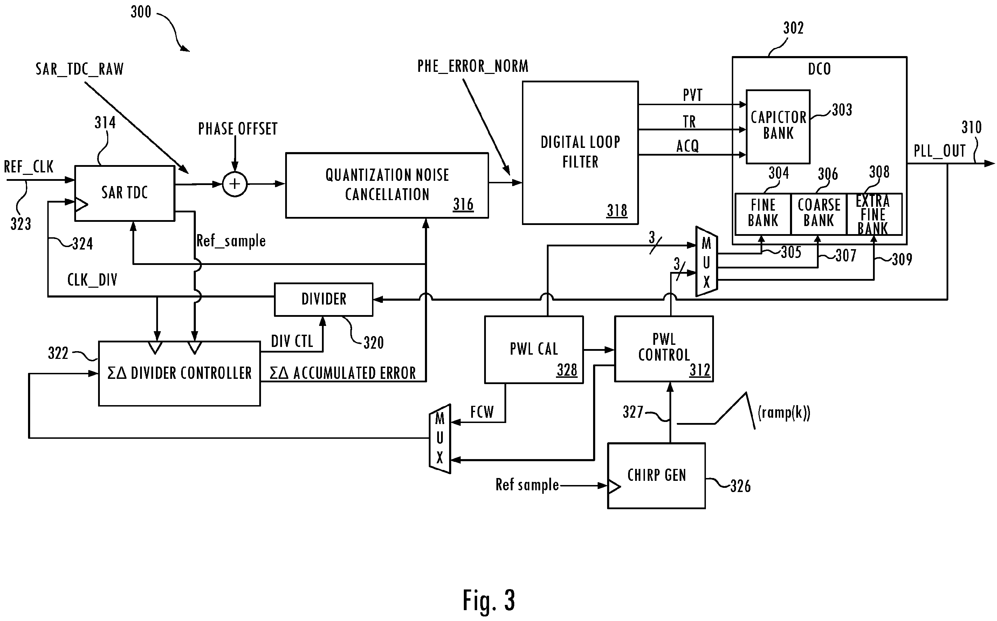

Fig. 3 illustrates a high level block diagram of an all-digital phase-locked loop (ADPLL) 300 used in the chirp generation block 106 in the radar system 100 of Fig. 1. While an ADPLL is shown, other PLLs architectures can also be used in radar system 100 such as an analog PLL or PLLs with combined analog and digital circuits. The exemplary ADPLL 300 includes a digitally controller oscillator (DCO) 302 having multiple banks of capacitors 303, 304, 306, and 308 to modulate the frequency of output signal 310. The DCO is implemented as an LC oscillator whose output frequency is determined by the inductance (L) and capacitance (C) of the LC circuit as $\frac{1}{\sqrt{LC}}$. The way the banks of capacitors 304, 306, and 308 are controlled suppresses frequency error periodicity in the frequency sweep as explained herein. The ADPLL 300 further includes piecewise linear (PWL) control unit 312. The control unit 312 switches capacitors in the banks of capacitors 304, 306, 308 in or out to decrease or increase the frequency of the output signal 310. The ADPLL 300 includes a phase detector 314, implemented as a successive approximation register (SAR) Time-to-Digital Converter (TDC), a quantization noise cancelling unit 316, a digital loop filter 318, feedback divider 320, and a divider control unit 322 implemented as a sigma delta modulator. The control unit 312 also controls the divider control unit 322. The TDC 314 compares the phase of the reference signal 323, supplied, e.g., from a crystal oscillator, with the phase of the feedback signal 324 and supplies a signal indicative of the phase difference, which is used to adjust the DCO 302 to eliminate the phase error. The divider control unit 322 in addition to controlling the integer divide value of feedback divider 320 supplies the quantization noise cancelling unit 316 with the quantization error associated with control of the feedback divider 320 so the quantization error is canceled before the phase error is supplied to the loop filter 318. The PLL further includes the chirp generator 326 that supplies ramp information 327 to PWL control unit 312 to indicate the chirp to be generated by ADPLL 300.

The ADPLL 300 supports two-point modulation through the chirp generator, the DCO modulation path control (PWL) control, and the DCO PWL calibration

**EP 4 783 457 A1**

block 328. The loop filter controls the capacitor bank 303, which may be formed by one or more capacitor banks in DCO 302, and is used for frequency acquisition (ACQ), tracking (TR), and process voltage and temperature (PVT) variations.

Referring still to Fig. 3, due to considerations of area efficiency and the trade-off between dynamic range and resolution, the DCO modulation path (MOD) using control signals 305, 307, and 309 has segmented capacitor banks: a fine capacitor bank 304, a coarse capacitor bank 306, and another (also referred to herein as extra) fine capacitor bank 308. In one or more embodiments, the extra fine capacitor bank and fine capacitor bank have the same structure and nominal capacitances. The fine capacitor banks can achieve minimum capacitor steps that are much smaller than the minimum capacitor steps of the coarse capacitor bank. For example, the minimum capacitance step for the fine bank may be in the tens of kHz and be at least an order of magnitude smaller than the minimum capacitor step (e.g., in the MHz range) for the coarse bank.

To achieve high chirp linearity calibration operations are performed. PWL calibration block 328 performs the calibration and measures the integral nonlinearity (INL) of the coarse capacitor bank 306, fine capacitor bank 304, and the extra fine capacitor bank 308, and the scaling factor of the fine banks for each coarse code. INL is a measure of how far the actual frequency is from the ideal frequency. The details of the PWL calibration can be found in U.S Patent Publication 2024/0080031, application number 18/239,309 entitled "Method of Controlling A Frequency-Modulated Oscillator of A Phase-Locked Loop Circuit" filed August 29, 2023, naming Nenad Pavlovic et al. as inventors, which application is incorporated herein by reference. The calibration operation will briefly be described herein to facilitate understanding of embodiments described. In brief, the control codes are calibrated so that the frequency output by the DCO for each control code is known and stored for use during chirp operation so that the desired frequency for the chirp operation can be accurately generated.

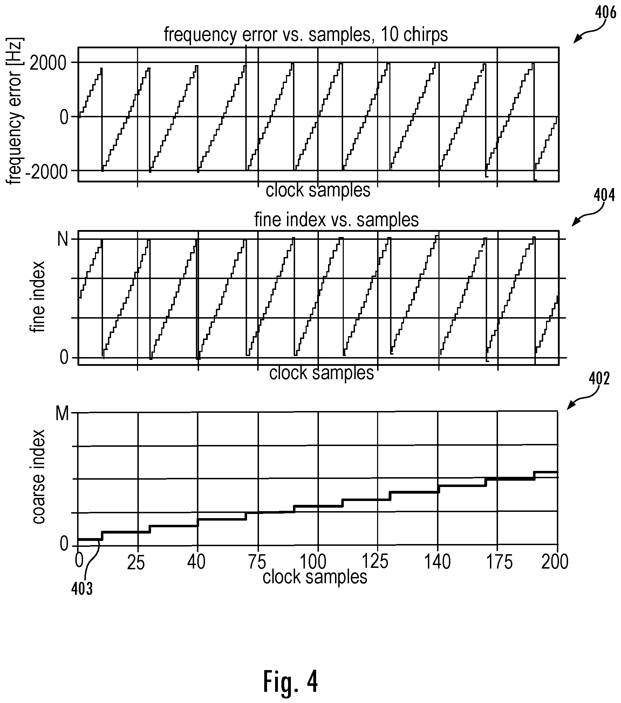

With reference to Fig. 4, the frequency sweep is achieved by setting a coarse index corresponding to a control code for the coarse capacitor bank and then utilizing the fine bank to increase the frequency by increasing the fine index corresponding to control codes for the fine capacitor bank until the frequency associated with the next coarse index is reached. That process is repeated for each coarse index. Each fine and coarse index corresponds to a particular control setting. Each change in coarse index shown at 402 results in a uniform, or substantially unifo coarse frequency step. Each coarse index corresponds to a control code for a particular capacitance setting for the coarse capacitor bank 306. For at least one coarse index, each of the fine frequency steps is also calibrated. As shown at 404 the fine index is repeated for each coarse index setting. While a similar fine calibration can be done for each coarse index, such a calibration would be time consuming. Instead, in at least some embodiments, the fine calibration is done once for one coarse index and then a scale factor is determined for the fine indexes used for the other coarse indexes. Thus, in at least some embodiments, rather than doing a complete calibration for each fine code for each coarse index, the calibration operation sets the fine index to maximize and minimize the frequency contribution from the fine capacitor bank for each coarse index. The difference in frequency between the maximum fine index and the minimum fine index is measured. That process is then repeated for all the coarse indexes. The ratio between the frequency difference measured at the first coarse index (e.g., measured at the lowest coarse index) and the frequency difference measured with subsequent coarse indexes provides the scale factor. For example, the fine bank with settings 1 to N is only calibrated once at the coarse 0 setting and then at each coarse setting above 0 the fine bank is toggled between setting 1 and setting N (just two steps) to generate the scale factor. When the fine bank is used at coarse steps higher than 0, the calibrated values (1 to N) are multiplied by the scale factor for that coarse step.

Even with calibration there will be residual frequency error for each DCO control code. During the chirp the frequency error will reflect DCO segmentation, for instance due to re-use of the fine bank. Still referring to Fig. 4, the fine index 404 goes from 0 to N for each coarse step (except the first step 403). In Fig. 4 it is assumed that there is a slope error present on the fine bank, resulting in periodicity of the frequency error. At a coarse transition, an error in the fine bank results in a frequency error that is repeated at each coarse step. The resultant periodic frequency error is shown at 406. Note that besides calibration errors, during the chirp operation DCO timing errors and temperature drift can also be present and further degrade chirp linearity performance.

Assuming an error variance in the calibration data, a generated chirp can have misalignment between the coarse and fine setting, resulting in frequency spurs. A specific spur that is related to repetitive misalignment between coarse and fine is directly linked to chirp slope. As an example, if there are $Ncoarse$ different coarse transmissions within chirp period $Tchirp$, the average periodicity of this can be calculated as $Tchirp/Ncoarse$. That calculation provides the spur frequency.

In order to address periodicity of fine bank frequency errors such as the frequency error 406 shown in Fig. 4, the DCO 302 includes the extra fine capacitor bank 308. The capacitance of the extra fine bank 308 combines with the capacitance of the coarse capacitor bank to break the periodicity of error related to the coarse index transition to thereby achieve higher chirp linearity for radar applications. Each chirp utilizes non-uniform frequency steps for each coarse step by randomizing selection of a fine control code for the extra fine capacitor bank for each coarse step and the frequency corresponding to the randomized fine control code is added to the frequency of the coarse step to achieve a non-uniform coarse step during a chirp. Thus, random selection of extra fine control settings provides randomization of the coarse frequency step. The use of non-uniform coarse steps during a chirp results in suppression of the periodic error 406 shown in Fig. 4.

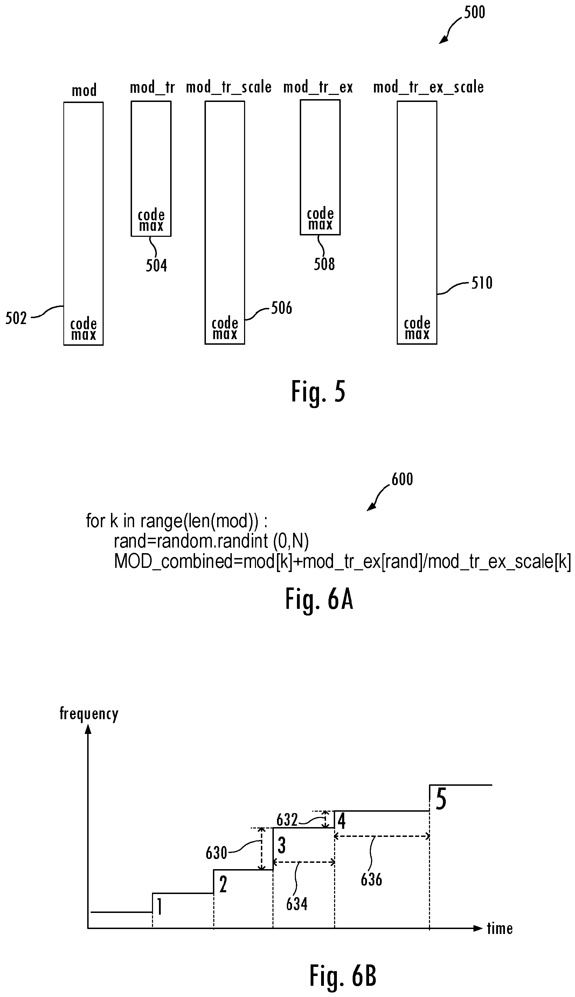

Fig. 5 illustrates calibration data available in one or more lookup tables (LUTs) 500. In an embodiment the calibration data as described in U.S. Patent Publication No. 2024/0080031 includes *mod* 502 for the coarse capacitor bank 306 (see Fig. 3), *mod_tr* 504 for the fine capacitor bank 304 (see Fig. 3) and scaling factor *(mod_tr_scale)* 506. The mod 502 data includes coarse codes (code _mod(k)) up to k=code max and associated frequencies determined during calibration. The *mod_tr* 504 data includes fine codes up to the maximum (code max) for the fine capacitor bank and associated frequencies determined during calibration. The scale factor storage mode_tr_scale 506 stores scale factors associated with each of the coarse codes. In addition, embodiments provide calibration data (*mod_tr_ex*) for the extra fine capacitor bank 308 shown in Fig. 3 and the scaling factors (*mod_tr_ex_scale*) for the extra fine capacitor bank 308. The scaling factors in mod_tr_ex_scale may be identical to mod_tr_scale 506 or separately determined.

The DCO control functionality uses a lookup table *MOD_combined LUT* that combines mod 502 and mod_tr_ex 508. Frequency thresholds for the *MOD_combined LUT* are generated as follows. The frequency threshold is the frequency corresponding to the particular coarse code or fine code. Referring still to Fig. 5, for each coarse code *mod(k),* which controls the coarse capacitor bank 306, where k is the kth entry in mod 502, the *MOD_combined LUT* frequency threshold is formed by the addition of the *mod* frequency threshold and the *mod_tr_ex* threshold. The *mod_tr_ex* threshold is randomly selected based on the random *modtr_ex(rand)* and is modified by the scale factor *1/mod_tr ex scale(k).* Scale factors for *mod_tr_ex* are stored in mod_tr_ex_scale 510. The pseudo code 600 in Fig. 6A illustrates the generation of the MOD_combined lookup table. In Fig. 6A, (len(mod)) corresponds to the number of elements in mod and N is the number of entries in mod_tr_ex. Note that while the term "random" is used herein, the generation of *MOD_combined LUT* uses pseudo-random capability available in programming code or hardware (e.g., linear feedback shift registers) and thus the term random or randomization as used herein is intended to describe the results of pseudo random functionality.

Fig. 6B illustrates the non-uniform nature of five coarse steps (1-5) and shows that the size of each frequency step is different. For example the height of frequency step 630 can be seen to be higher that the frequency step 632. In addition the duration at each coarse frequency code differs and is based on the size of the frequency step. The larger the frequency step, the shorter the time duration at that coarse code. Thus, the duration 634 of step 3 is shorter than the duration 636 of step 4. Note that the differences in height and duration of the frequency steps are exaggerated for ease of illustration.

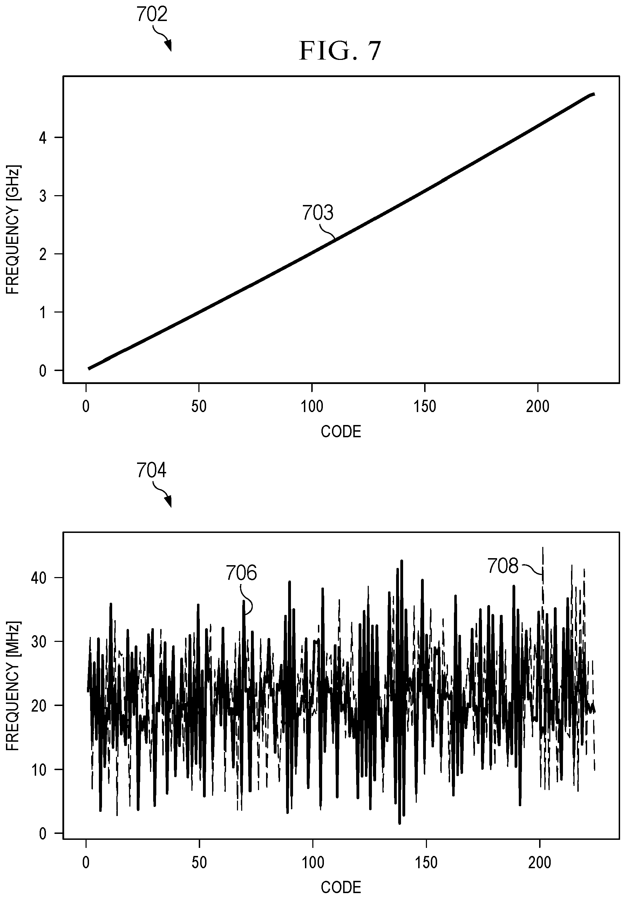

Fig. 7 illustrates two chirps in which the fine code in *mod_tr_ex* for the extra fine capacitor bank 308 is randomly selected and combined with the coarse code in *mod.* That achieves coarse transitions that are non-uniform by being randomized for each coarse step in each chirp. The top graph 702 in Fig. 7 illustrates the integration of the coarse codes for two chirps results in a linear ramp shown at 703. The bottom graph 704 shows the derivative of the top graph. The solid lines 706 illustrate the frequencies for each coarse code chirp 1 and the dashed lines 708 shows chirp 2. As can be seen the frequencies associated for each coarse step differ for both the first chirp and the second chirp. In addition, the frequency step for a coarse code in chirp 1 differs from the same coarse code in chirp 2 as the randomization is performed for each chirp. Referring back to the integration shown in 702 the integration for the two chirps are indistinguishable as the integration of the coarse steps for both chirps results in the linear ramp 703.

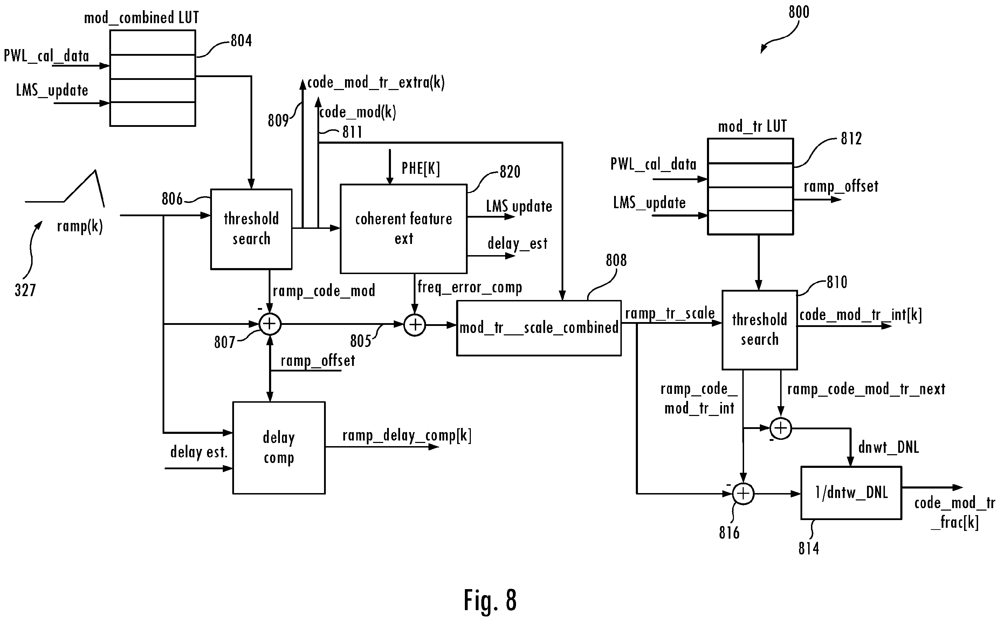

Fig. 8 illustrates aspects of an exemplary chirp control solution 800 that achieves non-uniform coarse frequency steps. The chirp control solution is implemented by a chirp controller that includes DCO modulation path control (PWL) control 312. The chirp controller may be further be implemented using control functionality implemented in data processing circuitry 116 shown in Fig. 1 and memory 118 storing data and software for the data processing circuitry to implement aspects of the control solution 800 described herein. In addition, some embodiments include chirp generator 326 as part of the chirp controller and other embodiments consider the chirp generator as a separate function. The chirp controller may utilize various combinations of hardware, memory, and software running on data processing circuitry according the needs of the particular embodiment. The control solution 800 is used for a chirp operation in an embodiment in which the DCO has, as shown in Fig. 3, the fine capacitor bank 304, the coarse capacitor bank 306, and the extra fine capacitor bank 308. The three capacitor banks are controlled using control codes determined by the chirp controller. The digital control codes are transmitted by PWL control over control lines 305, 307, and 309 to . the capacitor banks in DCO 302. The control codes tum on or off capacitors in the capacitor banks to achieve the desired frequency. The control solution 800 receives the ideal desired ramp (*ramp[k]*) 327 (see Fig. 3). The chirp control logic in the chirp controller searches lookup table mod_combined_LUT 804 in threshold search operation 806 for a *MOD_combined* threshold frequency that is closest to but below desired frequency point specified by ramp[k]. MOD_combined is determined as shown in Fig 6 as a coarse setting (mod[k]) in combination with a randomly selected fine setting (mod_tr_ex) scaled by the appropriate scale factor. The difference between the *MOD_combined* frequency (ramp_code_mod) and the frequency point specified by ramp[k] is a residual frequency 805 determined in summer 807 and supplied to scale block 808, which scales the residual frequency for each coarse step. Because the coarse steps no longer match the coarse steps used during calibration, the scale factors used by scale block 808 need to be adjusted as described further herein. The control logic supplies the control codes code_mod_tr_extra(k) 809 and code_mod(k) 811 corresponding to MOD_combined determined in the threshold search to the DCO to control the extra fine and coarse capacitor banks. The scaled residual frequency (ramp_tr_scale) is supplied to the threshold search block 810, which searches lookup table mod_tr_LUT 812 for the fine code (code_mod_tr_int[k]) that causes the fine capacitor bank 304 (shown in Fig. 3) to generate a frequency that is closest to but below the residual frequency. Block 810 provides the integer portion of the fine block control. Summer 816 subtracts the residual frequency from the frequency that is closest to but below the residual frequency to generate a second residual frequency that represents the frequency error after code_mode_tr_int[k] is applied. Block 814 provides the fractional portion of the fine bank control based on the second residual frequency, where dntw_DNL is the next code for the fine step. The remaining fine code (code_mod_tr_frac[k]) is calculated from the remaining frequency error and the next fine bank step (dntw_DNL) in block 814. Thus, the coarse bank has essentially been reconfigured using the extra fine capacitance bank and the coarse bank reconfiguration is applied to suppress periodic errors due to DCO bank segmentation in various embodiments of chirp generation. Block 820 provides LMS updates to the stored LUT data to reduce error. For instance, phase error can be coherently averaged over multiple chirps to lower jitter from the reference clock signal, and with the inverse transfer function referred back to frequency domain (DCO input), the error in the threshold for a given code can be calculated and that is then updated in order to lower the phase error. Block 820 receives inputs from threshold search in order to create a timestamp for phase error (PHE) sampling. Note that block 820 is optional for embodiments described herein and not needed for implementing the various embodiments described herein.

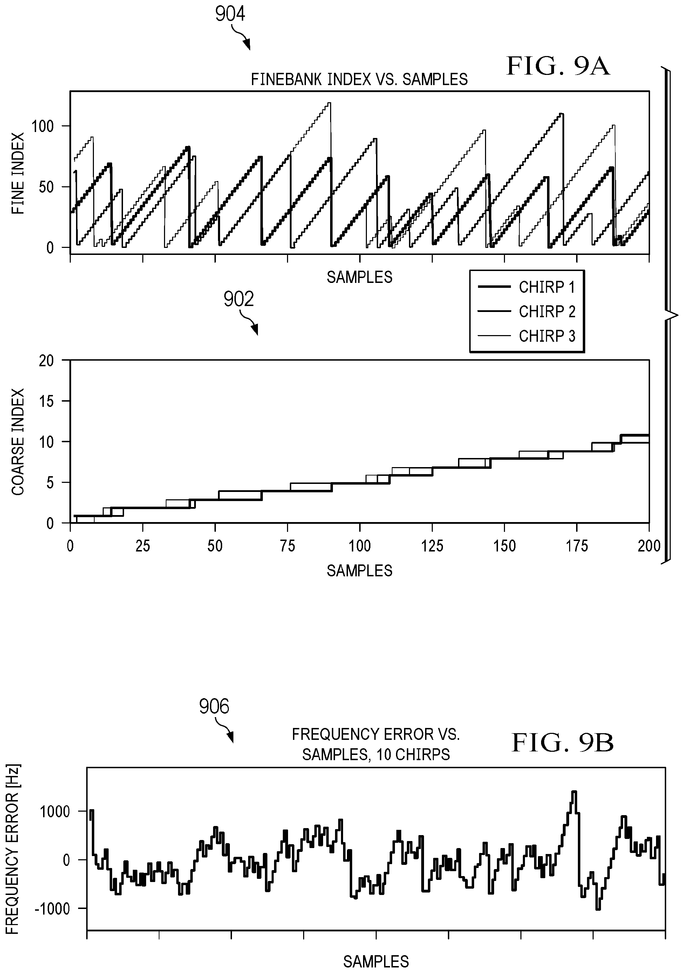

Combining the coarse threshold with a randomly selected fine threshold from the extra fine capacitor bank ensures that the effective coarse bank steps differ in frequency, which breaks the periodicity of the error. For example, Fig. 9A shows at 902 non uniform coarse steps for various coarse indexes for 3 chirps. Note that each coarse index lasts a different length of time since each coarse index is associated with a different frequency step. Fig. 9B also shows at 904 associated fine indexes for each of the different possible coarse indexes. As can be seen, when the coarse step is non-uniform, the fine indexes are also not repetitive (unlike what is shown in Fig. 4) as the fine index will start at a different point and end at a different point for each coarse step. Fig. 9B shows at 906 the residual frequency error for 10 chirps for non-uniform coarse transitions assuming the DCO had the fine bank slope error resulting in the periodic error shown Fig. 4. As can be seen in Fig. 9B the average frequency error over 10 chirps is lower than the frequency error shown in Fig. 4 with uniform coarse transitions and periodicity of the frequency error is suppressed with non-uniform coarse steps. Typically, radar application use more than 10 chirps, e.g., 100 or 1000 chirps, resulting in further averaging of frequency error. Note that the maximum control code for the fine bank index N* varies depending on the size of coarse step, resulting in a different periodicity for each coarse transition. Coarse bank index M* also effectively moves in time.

As stated earlier, calibration is imperfect. For INL errors some randomization occurs in the INL calibration step so the frequency error is already somewhat suppressed as compared to the frequency error shown in Fig. 4 but the frequency error as well as periodicity of the error is suppressed when non-uniform coarse step randomization is used.

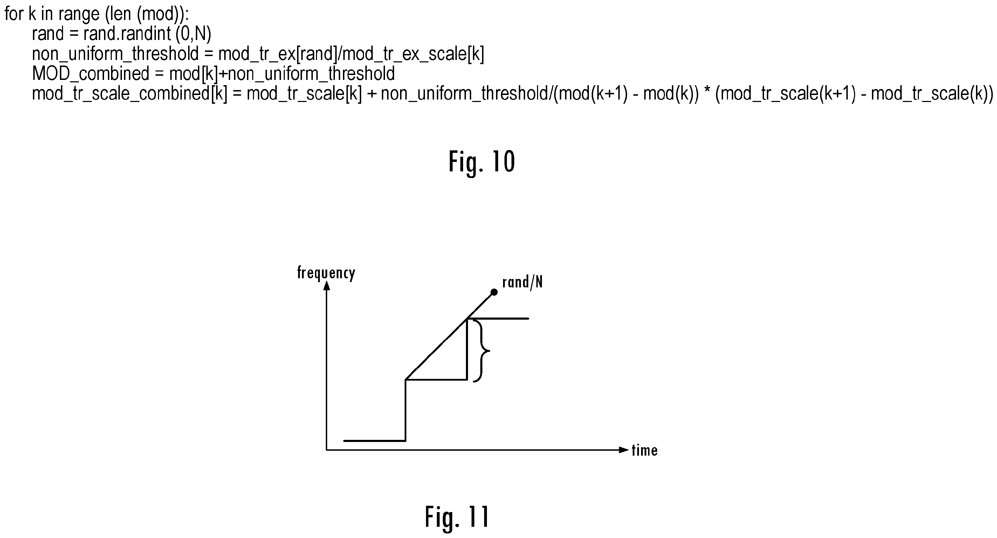

In embodiments, a scale factor correction is used to reduce error due to the mismatch between the coarse frequency steps based on the combination of the coarse capacitor bank and the extra fine capacitor bank and the calibrated scale factor. The *mod_tr_scale LUT* data is valid for the *mod LUT* thresholds. That is, the scale factors were calibrated without the extra fine capacitor bank frequency contribution. However, because thresholds of *mod combined LUT* are different from the calibrated *mod LUT*, the original calibrated scale factor (*mod_tr_scale*) needs to be adjusted to reflect the new threshold to reduce error. Embodiments utilize a correction based on *mod_tr scale* interpolation that removes the error due to different thresholds for *mod* and *MOD_combined*. Based on the new step size of the MOD_combined LUT, the scale factor mod_tr_scale_combined is linearly interpolated between the uniform coarse step scale factors mod_tr_scale(k) and mod_tr_scale(k+1). That correction is illustrated in the pseudo code shown in Fig. 10. That correction is utilized by the mod_tr_scale_combined block 808 shown in Fig. 8.

The frequency step between mod [k] and mod [k+1] is Δmod and thus Δmod = mod(k+1) - mod(k). The additional frequency for the step is defined as mod_tr_ex [rand]/mod_tr_ex_scale[k] as shown, e.g., in Fig. 6A. If the random number is such that the additional frequency from mod_tr_ex[rand]/mod_tr_ex_scale[k] corresponds to Δmod then the ratio between (mod_tr_ex[rand]/mod_tr_ex_scale[k]) / Δmod ≈ 1. In that case the scale factor mod_tr_scale_combined (see 808 in Fig. 8) is equal to the accumulated scale_factor plus one scale_factor_step, where a scale_factor_step = mod_tr_scale(k+1)-mod_tr_scale(k). If the random number is such that the frequency step is larger than Δmod (for example 1.2 × Δmod) then the ratio between (mod_tr_ex[rand]/mod_tr_ex_scale[k]) / Δmod > 1, which results in the scale factor mod_tr_scale_combined being equal to the accumulated scale factor plus (1.2 × scale_factor_step). In that way the scale factor depends on the ratio and is interpolated and added to the current scale_factor based on a uniform coarse step. Thus, mod_tr_scale_combined(k)=mod_tr_scale(k) + ratio × scale_factor_step, where ratio=non_uniform_threshold / Δmod and non_uniform_threshold = mod_tr_ex[rand]/-mod_tr_ex_scale[k].

If the random number is such that the frequency step is smaller than Δmod (for example 0.8 × Δmod) then the ratio between (mod_tr_ex[rand]/mod_tr_scale_ex [k]) / Δmod < 1, which results in the scale factor mod_tr_scale_combined being equal to the accumulated scale factor plus (0.8 × scale_factor_step). In that way the scale factor depends on the ratio and is interpolated and added to the current scale_factor. Thus, if mod_tr_ex [rand]/mod_tr_ex_scale[k]) equals Δmod, then scaling just adds a scale factor step without the need for interpolation. However if mod_tr_ex[rand]/mod_tr_ex_scale [k]) is higher (or lower) than Δmod then an interpolation correction should be applied.

Other embodiments use a different scale factor correction approach. For example the scale factor can be based on the ratio between fine and coarse bank overlap, mod_tr_scale_combined[k]=mod_tr_scale[k] + (rand/Nsteps× scale_factor_step). Fig. 11 helps understand calculation of the corrected scale factor. The corrected scale_factor is calculated from the ratio of the random number (rand) and $N_{steps}$, where $N_{steps}$ is the number of fine steps (mod_tr) that cover one coarse step (mod). For example if $N_{steps}$=64 and the random number is 128 then the ratio is 2, meaning that scale factor is corrected by: mod_tr_scale_combined[k]=mod_tr_scale[k]+(2×scale_factor_step).

To make a more accurate calculation with this correction approach, $N_{steps}$ should be determined over all coarse codes as Nx is not necessarily constant in an LC VCO. .

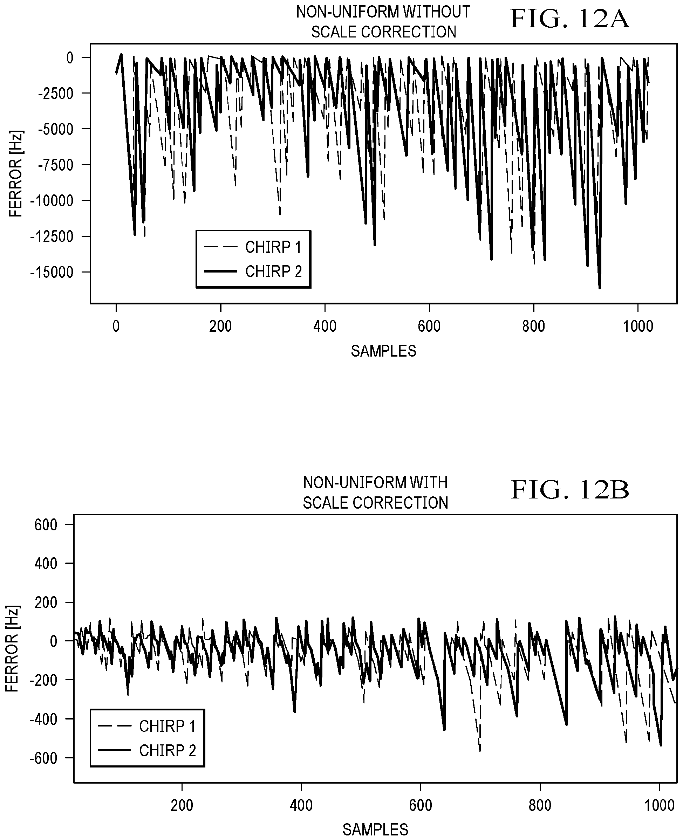

The use of the corrected scale factors reduce errors. Fig. 12A shows the frequency error for two chirps for 1024 samples for non-uniform coarse steps for a 1GHz chirp but without the correction based on *mod_-tr_scale* interpolation. Fig. 12B illustrates the frequency error in Hz with non-uniform coarse steps but with frequency correction based on the *mod_tr_scale* interpolation. As shown in Fig. 12B, applying the scale factor correction described above, reduces the frequency error from a frequency error of greater than 10kHz to a level of several hundred of Hz.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

In this specification, example embodiments have been presented in terms of a selected set of details. However, a person of ordinary skill in the art would understand that many other example embodiments may be practiced which include a different selected set of these details. It is intended that the following claims cover all possible example embodiments. Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements.

**Claims**

1. A method comprising:

   generating an output signal (310) of an oscillator (302), the output signal having a frequency ramp from a starting frequency to an ending frequency; and
   the oscillator using non-uniform coarse frequency steps to generate the output signal.

2. The method as recited in claim 1 further comprising: generating the non-uniform coarse frequency steps by using a coarse capacitance of a coarse bank of capacitors (306) determined in conjunction with a randomly selected fine capacitance of a fine bank of capacitors (308).

3. The method as recited in claim 2 further comprising storing coarse capacitance control codes and fine capacitance control codes in a memory (118).

4. The method as recited in claim 3 further comprising storing a plurality of frequency thresholds, each of the frequency thresholds being a combination of a first frequency corresponding to one of the coarse capacitance control codes in combination with a second frequency corresponding to a randomly selected one of the fine capacitance control codes.

5. The method as recited in claim 4 further comprising:

receiving an indication (327) of a desired frequency to be generated by the oscillator of a phase-locked loop (300) for a chirp operation; determining one of the frequency thresholds that has a threshold frequency below the desired frequency in a threshold search (806); determining a residual frequency (805) based on a difference between the desired frequency and the threshold frequency; and determining a second fine capacitance control code for a second fine bank of capacitors (304) using the residual frequency.

6. The method as recited in claim 5 further comprising using calibration data to scale the residual frequency based on a current coarse frequency step determined according to the one of the frequency thresholds and a stored scaling factor.

7. The method as recited in claim 6 further comprising adjusting the stored scaling factor to account for a frequency difference between the current coarse frequency step and a coarse step used during calibration.

8. An apparatus comprising:

a phase-locked loop (300) including an oscillator (302), the oscillator including a coarse bank of capacitors (306), a first fine bank of capacitors (308), and a second fine bank of capacitors(304); a chirp controller (800, 312, 116, 118) to cause the phase-locked loop to provide an output signal (310) with a plurality of frequencies during a chirp operation; and wherein during the chirp operation the chirp controller supplies the oscillator with control codes to the first fine bank of capacitors and to the coarse bank of capacitors that cause the phase-locked loop to utilize non-uniform coarse frequency steps to generate the output signal.

9. The apparatus as recited in claim 8 wherein the first fine bank (308) of capacitors is used in conjunction with the coarse bank of capacitors to generate the non-uniform coarse frequency steps.

10. The apparatus as recited in claim 8 or 9 wherein each of the non-uniform coarse frequency steps is determined according to a coarse capacitance control code supplied to the coarse bank of capacitors and a fine capacitance control code randomly selected to be simultaneously supplied to the first fine bank of capacitors.

11. The apparatus as recited in claim 10 wherein a plurality of fine capacitance control codes are supplied to the second fine bank of capacitors between coarse frequency steps as part of the chirp operation.

12. The apparatus as recited in claim 10 or 11 further comprising a memory (118) to store coarse capacitance control codes including the coarse capacitance control code and fine capacitance control codes including the fine capacitance control code and scale factors for the fine capacitance control codes.

13. The apparatus as recited in claim 12 wherein the memory further stores a plurality of first frequency thresholds, each of the first frequency thresholds being a frequency determined by one of the coarse capacitance control codes in combination with a random one of the fine capacitance control codes.

14. The apparatus as recited in claim 13,

wherein the chirp controller receives an indication of a desired frequency to be generated by an oscillator for the chirp operation; and wherein the chirp controller performs a threshold search (806) of a plurality of frequency thresholds to find a frequency threshold among the frequency thresholds that is closest to and below the desired frequency, each of the frequency thresholds corresponding to a first frequency corresponding to one of the coarse capacitance control codes summed with a second frequency corresponding to one of the fine capacitance control codes randomly assigned to the one of the coarse capacitance control codes.

15. The apparatus as recited in claim 14,

wherein the controller determines a residual frequency (805) based on a difference between the desired frequency (327) and the frequency threshold; and wherein the controller determines a second fine capacitance control code for a second fine bank of capacitors using the residual frequency.

Fig. 1

Fig. 2

Fig. 3

**Fig. 4**

500

mod    mod_tr    mod_tr_scale    mod_tr_ex    mod_tr_ex_scale

code
max

504

code
max

508

510

502

code
max

code
max

506

code
max

## Fig. 5

600

```
for k in range(len(mod)) :
    rand=random.randint (0,N)
    MOD_combined=mod[k]+mod_tr_ex[rand]/mod_tr_ex_scale[k]
```

## Fig. 6A

frequency

5

632

4

630

3

634

2

636

1

time

## Fig. 6B

FIG. 7

Fig. 8

904

## FINEBANK INDEX VS. SAMPLES

FIG. 9A

902

906

## FREQUENCY ERROR VS.
SAMPLES, 10 CHIRPS

FIG. 9B

```
for k in range (len (mod)):
    rand = rand.randint (0,N)
    non_uniform_threshold = mod_tr_ex[rand]/mod_tr_ex_scale[k]
    MOD_combined = mod[k]+non_uniform_threshold
    mod_tr_scale_combined[k] = mod_tr_scale[k] + non_uniform_threshold/(mod(k+1) - mod(k)) * (mod_tr_scale(k+1) - mod_tr_scale(k))
```

## Fig. 10

## Fig. 11

EP 4 783 457 A1

NON-UNIFORM WITHOUT
SCALE CORRECTION

FIG. 12A

NON-UNIFORM WITH
SCALE CORRECTION

FIG. 12B

Europäisches
Patentamt
European
Patent Office
Office européen
des brevets

# EUROPEAN SEARCH REPORT

**Application Number**

EP 25 15 3280

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WU WANGHUA ET AL: "A 56.4-to-63.4 GHz Multi-Rate All-Digital Fractional-N PLL for FMCW Radar Applications in 65 nm CMOS", IEEE JOURNAL OF SOLID-STATE CIRCUITS, IEEE, USA, vol. 49, no. 5, 1 May 2014 (2014-05-01), pages 1081-1096, XP011546099, ISSN: 0018-9200, DOI: 10.1109/JSSC.2014.2301764 [retrieved on 2014-04-21] * Section III; Section IV, Section V; figures 3,4,10,11,12 * ----- | 1-15 | INV. H03B23/00 |

**TECHNICAL FIELDS SEARCHED (IPC)**

H03B
H03D

The present search report has been drawn up for all claims

| Place of search | Date of completion of the search | Examiner |
|---|---|---|
| The Hague | 7 July 2025 | Jesus, Paulo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20240080031 A
- US 18239309 B, Nenad Pavlovic